Europäisches Patentamt
European Patent Office
Office européen des brevets

(11) Publication number: **0 240 726 A2**

# (12) EUROPEAN PATENT APPLICATION

(21) Application number: **87103113.4**

(22) Date of filing: **05.03.87**

(51) Int. Cl.4: **G03F 7/10**

(30) Priority: **05.03.86 JP 47852/86**
**05.03.86 JP 47853/86**

(43) Date of publication of application:
**14.10.87 Bulletin 87/42**

(84) Designated Contracting States:
**DE FR GB**

(71) Applicant: **DAIKIN INDUSTRIES, LIMITED**
**No. 1-12-39, Umeda Kita-ku**
**Osaka-shi Osaka-fu(JP)**

(72) Inventor: **Tamaru, Shinji**
**31-10, Senriyama Nishi 3-chome**
**Suita-shi Osaka-fu(JP)**
Inventor: **Taira, Kazuo**
**18-1, Senrioka Nishi**
**Suita-shi Osaka-fu(JP)**
Inventor: **Mizuguchi, Morio**
**21-21, Hitotsuya 2-chome**
**Settsu-shi Osaka-fu(JP)**

(74) Representative: **Patentanwälte Dr. Solf & Zapf**
**Zeppelinstrasse 53**
**D-8000 München 80(DE)**

## (54) Resist material.

(57) A resist material comprising a polymer containing at least one structural unit (1) represented by the formula

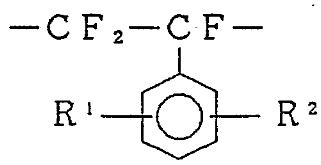

(1)

wherein $R^1$ is hydrogen atom, alkyl having 1 to 3 carbon atoms, alkoxyl having 1 to 3 carbon atoms or halogen atom, $R^2$ is hydrogen atom or haloalkyl having 1 to 3 carbon atoms.

Fig. 1

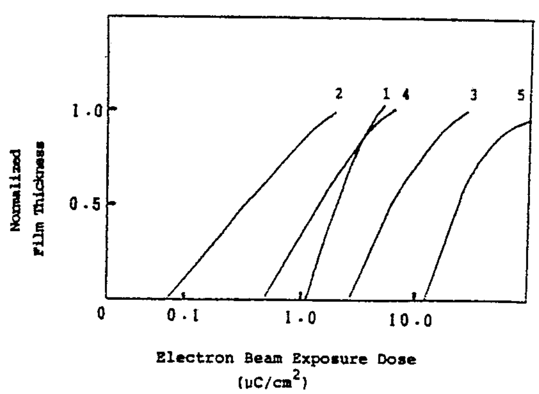


Xerox Copy Centre

## Resist material

The invention relates to a resist material of the negative type which is sensitive to high-energy rays and which has high sensitivity and resolution and outstanding resistance to heat and dry etching.

In the electronics industry, printing industry, precision machinery industry, etc. , a resist coating is used to form the designed pattern on the substrate, for example, for manufacturing magnetic bubble, integrated circuits, printing plates, shadow masks, etc. A solution of resist material is applied, for example, to the surface of a semiconductor substrate, and the formed coating is baked when required to form a resist coating, and then irradiated with high-energy rays to form a latent image of the designed pattern in the resist coating. The image is thereafter developed with a suitable developer.

Already known as such a resist material of the negative type is chloromethylated polystyrene (CMS) disclosed, for example, in Japanese examined patent publication (Kokoku) No. 50263/1981 and Japanese unexamined patent publication (Kokai) No. 109943/1982. This compound has high resistance to heat and to dry etching but is demanded to be improved in sensitivity and resolution.

In order to obtain an improved resist material, the present applicant has developed a resist material comprising fluoromethylated polystyrene (FMS) and has filed a patent application (Japanese patent application No. 192245/1984).

An object of the invention is to provide a resist material which has higher sensitivity and resolution than that comprising the above FMS.

Another object of the invention is to provide a resist material which is well balanced in sensitivity and resolution.

Still another object of the invention is to provide a resist material which has a high glass transition temperature (Tg) and high resistance to heat.

The above and other objects of the invention will become apparent from the following description.

The present invention provides a resist material comprising a polymer containing at least one structural unit (1) represented by the formula

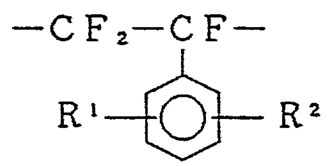

(1)

wherein $R^1$ is hydrogen atom, alkyl having 1 to 3 carbon atoms, alkoxyl having 1 to 3 carbon atoms or halogen atom, $R^2$ is hydrogen atom or haloalkyl having 1 to 3 carbon atoms.

In the above formula, examples of halogen atoms are chlorine, fluorine and bromine and examples of haloalkyl are chloromethyl, chloroethyl, fluoromethyl, fluoropropyl, bromoethyl, bromopropyl, etc.

The sensitivity of negative-type resist materials generally increases with an increase in the weight average molecular weight, but the resolution thereof decreases. Accordingly, it is necessary to lower the molecular weight in order to enhance the resolution. However, it is possible, in the present invention, to obtain a resist material which is high in resolution and sensitivity and has excellent resistance to heat, without decreasing the molecular weight. The present resist material is particularly well balanced in sensitivity and resolution and has excellent resistance to dry etching.

Japanese Kokai No. 79247/1984 discloses a material which is sensitive to electrolytic radiation and contains as a main component a polymer having a recurring unit (A) represented by the formula

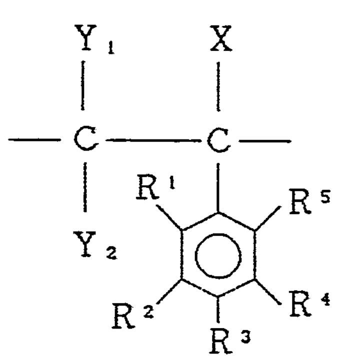

(A)

wherein X is hydrogen atom, methyl or halogen atom, $Y_1$ and $Y_2$ are respectively hydrogen atom, methyl or halogen atom, $R^1$, $R^2$, $R^3$, $R^4$ and $R^5$ are respectively hydrogen atom, alkyl having 1 to 3 carbon atoms, alkoxyl having 1 to 3 carbon atoms, halogen atom, haloalkyl having 1 to 3 carbon atoms or haloalkoxyl having 1 to 3 carbon atoms. In the polymer, at least part of X and at least part of $Y_1$ and $Y_2$ are halogen atoms, and at least part of $R^1$, $R^2$, $R^3$, $R^4$ and $R^5$ are haloalkyl having 1 to 3 carbon atoms or haloalkoxyl having 1 to 3 carbon atoms. The polymer is prepared by polymerizing or copolymerizing a monomer of the formula (B) or a mixture thereof with a monomer of the formula (C) respectively, and further halogenating the resulting polymer or copolymer. As the monomers of the formulae (B) and (C), only enumerated are o,m,p-methylstyrene, p-ethylstyrene, p-methoxystyrene, α-methylstyrene and styrene. Further, the halogenating agents include only chlorinating, iodinating and brominating agent. Although it seems to include the present polymer, the polymer of Kokai No. 79247/1984 is in fact quite different from the present polymer.

The polymer used in the present invention is a polymer containing at least one structural unit (1) represented by the formula

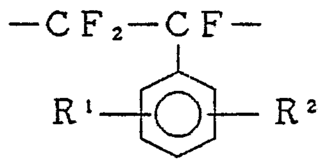

(1)

wherein $R^1$ is hydrogen atom, alkyl having 1 to 3 carbon atoms, alkoxyl having 1 to 3 carbon atoms or halogen atom, $R^2$ is hydrogen atom or haloalkyl having 1 to 3 carbon atoms. The present polymer includes a homopolymer containing only the structural unit of the above formula (1), a copolymer containing at least two kinds of the above structural units, or a copolymer containing the above structural unit and a structural unit derived from other copolymerizable monomer. In the last copolymer, the amount of the structural unit of the formula (1) is preferably at least about 50% (wt%, same as hereinafter), more preferably at least about 80%. Examples of other copolymerizable monomers are styrene, α-methylstyrene, o-, m-or p-methylstyrene, o-, m-or p-ethylstyrene, o-, m-or p-methoxystyrene, aromatic vinyl compounds other than those represented by the formula (1), methyl acrylate, ethyl acrylate or like acrylic ester, vinyl acetate, etc.

The polymer of the invention is prepared by homopolymerizing or copolymerizing a monomer (2) which has a group $CF_2=CF$ in place of $-CF_2-CF-$in the unit of the formula (1) according to the conventional method. Among the monomer (2), p-methyltrifluorostyrene, p-fluoromethyltrifluorostyrene, etc. are known compounds. Monomers (2) other than the above can be prepared by chloromethylating, chlorinating or chloromethylating followed by fluorinating the above known methyltrifluorostyrene or fluoromethyltrifluorostyrene.

Alternatively, the present polymer can be obtained by preparing a polymer having a structural unit of the formula (1) and then chloromethylating, chlorinating or chloromethylating followed by fluorinating the polymer. The following is an example showing schematically a method of preparing the present polymer.

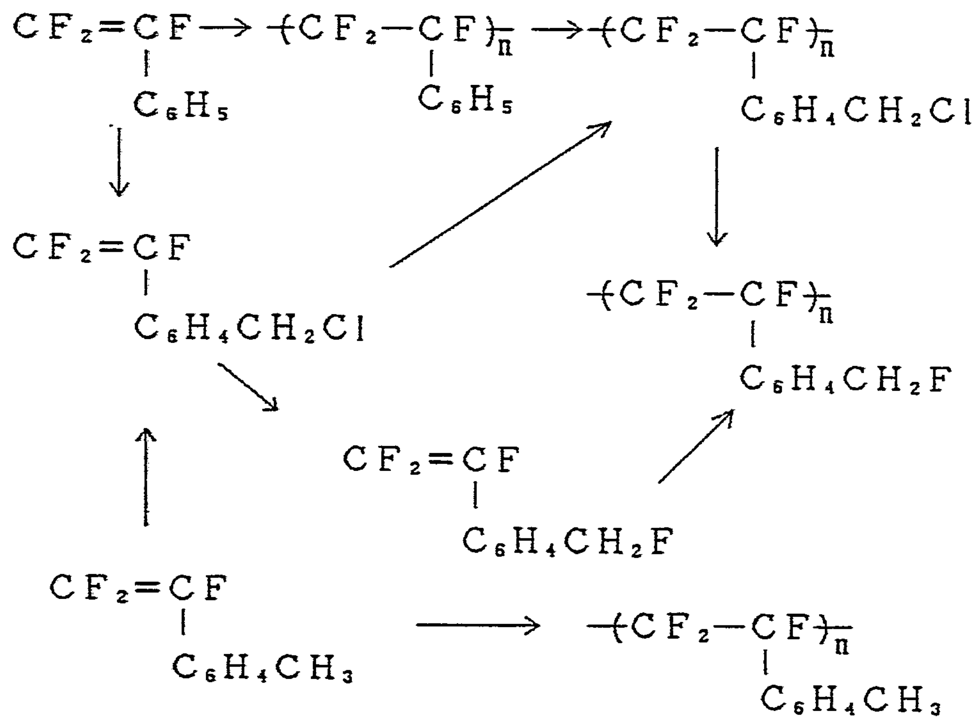

Chloromethylation, chlorination and fluorinating can be conducted according to the conventional method. For example, polytrifluorostyrene is chloromethylated with chloromethyl methyl ether or like chloromethylating agent in the presence of a catalyst such as chlorosulfonic acid or like protonic acid, aluminum chloride or like Lewis acid, etc.

Chlorination can be carried out according to, for example, a method described in Journal of American Chemical Society 76, 3146 (1954). Chlorination is conducted radically in a suitable solvent such as chloroform with use of N-chlorosuccinimide in the presence of light or benzoyl peroxide, azobisisobutyronitrile or like radical initiator.

Fluorination can be conducted according to, for example, a method disclosed in Japanese Kokai 192245/1984. For example, poly(chloromethylated trifluorostyrene) is dissolved in toluene and fluorinated with an aqueous solution of potassium fluoride in the presence of cetyltrimethylammonium bromide as an interphase transfer catalyst to obtain poly(fluoromethylated trifluorostyrene).

As a solvent, preferable are benzene and like aromatic hydrocarbons, carbon tetrachloride, 1,2-dichloroethane, 1,1,2-trichloroethane and like halogenated hydrocarbons. Particularly preferable are those which do not react with a halogen radical.

In the invention, the polymer having a structural unit of the formula (1) can be prepared by a suitable method and conditions. For example, bulk polymerization, solution polymerization, suspension polymerization, emulsion polymerization or like process can be empolyed. Useful initiators are compounds which produce a free radical under the reaction conditions. Examples of preferred initiators are diisopropylperoxy dicarbonate, ammonium persulfate and like peroxides, azobisisobutyronitrile and like azonitriles, etc. The initiator is used usually in an amount of 1 to 1000 wt. ppm based on the monomer, but the amount is not limited to this range because it is dependent on the desired degree of polymerization of polymer, reaction time and temperature and like factors. The reaction temperature is -80 to 250°C in accordance with the decomposition temperature of the initiator. Generally the temperature is preferably in the range of 40 to 150°C. Solvents useful for solution polymerization are benzene, toluene, xylene and like aromatic hydrocarbons, tetrahydrofuran, dimethylformamide, dimethyl sulfoxide, acetonitrile, methyl ethyl ketone, dioxane, carbon disulfide, etc. These solvents are used singly or in mixture.

The polymer is separated from the reaction mixture by a usual method, for example, by dissolving the mixture in a solvent which is capable of dissolving the polymer and thereafter re-precipitating the polymer alone with addition of methanol or like organic liquid in which the polymer is insoluble. Preferably the polymer has a weight average molecular weight ($\bar{M}$ w) of about 5,000 to about 1,000,000.

The resist material of the invention, which comprises the above polymer, affords resist coatings having exceeding high sensitivity and resolution (gamma value). The resist coating is developed in known manner with a known developer. Examples of useful developers are acetone, methyl ethyl ketone, methyl, isobutyl ketone and like ketones; mixtures of such ketones and methanol, isopropanol (IPA) and like alcohols; ethyl acetate, amyl acetate and like fatty acid esters; mixtures of such esters and alcohols; monochlorobenzene, toluene, xylene and like aromatic hydrocarbons; mixtures of such hydrocarbons and alcohols; etc.

It is possible, in the present invention, to obtain a resist material which is high in resolution and sensitivity and has excellent resistance to heat, without decreasing the molecular weight. The present resist material is particularly well balanced in sensitivity and resolution and has excellent resistance to dry etching.

The present invention will be described below with showing examples and comparison examples, in which part and percentage are all by weight.

Fig. 1 shows the electron ray sensitivity curves of resist coatings of the invention. In the figure, 1 to 4 correspond to the polymers of Examples 1 to 4, and 5 corresponds to the polymer of Comparison Example 1.

Example 1

To 100ml of water were added 20g of trifluorostyrene monomer, 150mg of ammonium persulfate and 2 g of n-dodecylamine hydrochloride to form a homogeneous solution. The vessel of the solution was placed into a stream of nitrogen having a constant temperature of 60°C to subject the mixture to polymerization for 7 hours. After the completion of polymerization, the mixture was added to methanol to obtain a polymer. The polymer was washed with water and methanol repeatedly and then dried under a reduced pressure.

The polymer was found to have $\bar{M}w$ of $4.7X10^5$, $\bar{M}n$ of $1.2X10^5$ and $\bar{M}w/\bar{M}n$ of 3.9 by gel permeation chromatography (GPC) using polystyrene as a standard substance and methyl ethyl ketone (MEK) as a solvent. Further the polymer was found to have a Tg of 190°C and thermal decomposition initiation temperature (TD) of 328.5°C.

The polymer was dissolved into monochlorobenzene to prepare 5% solution and the solution was filtered through 0.5µm polytetrafluoroethylene membrane filter to obtain a resist solution. The resist solution was applied dropwise to a silicon wafer and the wafer was rotated at 500rpm for 5 seconds and then at 1000rpm for 90 seconds to form a coating. The coating was heat-treated in an oven at 100°C for 30 minutes to obtain a coating of 0.5 µm in thickness.

The coating was exposed to electron beams with an electron beams delineation apparatus (a product of Kabushiki Kaisha Elionix, Japan, ERE-302, acceleration voltage 20kV, irradiation current 1nA) to form a pattern in the coating. The pattern was developed at 23°C by immersing the coated wafer in toluene for 60 seconds. The coating was then rinsed with a mixture of toluene-isopropanol (1:1 in volume ratio) at 23°C for 15 seconds and subsequently rinsed with isopropanol (IPA) at 23°C for 15 seconds, and then dried in air. The exposure dose required for gelation (Di) was $1.1\mu C/cm^2$, and exposure dose required for obtaining 50% normalized film thickness remainings ($D_{0.5}$) was $2.3\mu C/cm^2$. In this case it has a resolution enough to produce a line-and-space pattern with 0.5-µm lines and 0.5-µm spacings. In the coating, the patterns 0.5µmX0.5µm remain perfectly which show an excellent resolution and adhesiveness.

Test Example 1 (Resistance to dry etching)

A reactive ion etching was conducted with use of $CF_4$ in order to check the polymer of Example 1 for resistance to dry etching. As the dry etching apparatus was used DEM-451, a product of Nichiden ANELVA Kabushiki Kaisha, Japan. The followings are conditions for etching.

Etching gas $CF_4$ (Pure)
Etching pressure 13Pa (0.1 torr)
Etching gas flow rate 100sccm
Power density $0.16W/cm^2$
Bias voltage 270V
Substrate temperature 10°C

The relative etching rate was 0.34 to the etching rate of poly(methyl methacrylate) (PMMA).

Example 2

Into 60ml of chloromethyl methyl ether was dissolved 1g of the polymer of Example 1, and further added thereto 14g of chlorosulfonic acid as a catalyst. The mixture was reacted at 32°C for 8 hours. After the completion of reaction, the mixture was added to methanol to obtain a polymer which was washed with water and methanol repeatedly and dried in a reduced pressure. IR spectra showed an absorption of chloromethyl at 1270cm$^{-1}$, $^{1}$H-NMR indicated a $CH_2$ peak of chloromethyl at $\delta$=4.3ppm and rate of chloromethylation was 92%.

The polymer was dissolved into monochlorobenzene to prepare 5% solution and the solution was filtered through 0.5µm polytetrafluoroethylene membrane filter to obtain a resist solution. The resist solution was applied dropwise to a silicon wafer and the wafer was rotated at 500rpm for 5 seconds and then at 1000rpm for 90 seconds to form a coating. The coating was heat-treated in an oven at 100°C for 30 minutes to obtain a coating of 0.5µm in thickness.

The coating was exposed to electron beams with the same electron beams delineation apparatus as in Example 1 to form a pattern in the coating. The pattern was developed at 23°C by immersing the coated wafer in toluene for 60 seconds. The coating was then rinsed with a mixture of toluene-IPA (1:1 in volume ratio) at 23°C for 15 seconds and subsequently rinsed with IPA at 23°C for 15 seconds, and then dried in air. The exposure dose required for gelation (Di) was 0.07µC/cm$^2$, and exposure dose required for obtaining 50% normalized film thickness remainings ($D_{0.5}$) was 0.3 µC/cm$^2$. In this case it had a resolution enough to produce a line-and-space pattern with 1-µm lines and 1-µm spacings.

Example 3

To 200ml of water were added 20g of trifluoro-p-methylstyrene, 300mg of ammonium persulfate, 300mg of n-dodecylamine hydrochloride and 120mg of lauryl mercaptan to form a homogeneous solution. The vessel of the solution was placed into a stream of nitrogen having a constant temperature of 60°C to subject the mixture to polymerization for 7 hours. After the completion of polymerization, the mixture was added to an aqueous solution of potash alum to obtain a polymer. The polymer was washed repeatedly and then dried in a reduced pressure.

The polymer was found to have $\bar{M}w$ of 28X10$^4$, $\bar{M}n$ of 8X10$^4$ and $\bar{M}w/\bar{M}n$ of 3.5 by GPC using polystyrene as a standard substance and tetrahydrofuran (THF) as a solvent. Further the polymer was found to have a Tg of 213°C and thermal decomposition initiation temperature (TD) of 321°C.

The polymer was dissolved into monochlorobenzene to prepare 5% solution and the solution was filtered through 0.5µm polytetrafluoroethylene membrane filter to obtain a resist solution. The resist solution was applied dropwise to a silicon wafer and the wafer was rotated at 500rpm for 5 seconds and then at 1000rpm for 90 seconds to form a coating. The coating was heat-treated in an oven at 100°C for 30 minutes to obtain a coating of 0.5µm in thickness.

The coating was exposed to electron beams with the same electron beams delineation apparatus as in Example 1 to form a pattern in the coating. The pattern was developed at 23°C by immersing the coated wafer in toluene for 60 seconds. The coating was then rinsed with a mixture of toluene-IPA (1:1 in volume ratio) at 23°C for 15 seconds and subsequently rinsed with IPA at 23°C for 15 seconds, and then dried in air. The exposure dose required for gelation (Di) was 2.7µC/cm$^2$, and exposure dose required for obtaining 50% normalized film thickness remainings ($D_{0.5}$) was 6.1 µC/cm$^2$. In this case it had a resolution enough to produce a line-and-space pattern with 1-µm lines and 1-µm spacings.

Example 4

Into 38g of chloroform was dissolved 2g of the polymer obtained in Example 3. To the solution were added 1.7g of N-chlorosuccinimide as a chlorinating agent and 190mg of azobisisobutyronitrile as a radical initiator. The mixture was reacted at 65°C under reflux for 8 hours. After the completion of reaction, the mixture was added to methanol to obtain a polymer which was washed with water and methanol repeatedly and dried in a reduced pressure. IR spectra showed an absorption of chloromethyl at 1270cm$^{-1}$, $^{1}$H-NMR indicated a $CH_2$ peak of chloromethyl at $\delta$=4.3ppm and rate of chloromethylation was 48%.

The polymer was dissolved into monochlorobenzene to prepare 5% solution and the solution was filtered through 0.5µm polytetrafluoroethylene membrane filter to obtain a resist solution. The resist solution was applied dropwise to a silicon wafer and the wafer was rotated at 500rpm for 5 seconds and then at 1000rpm for 90 seconds to form a coating. The coating was heat-treated in an oven at 100°C for 30 minutes to obtain a coating of 0.5µm in thickness.

The coating was exposed to electron beams with the same electron beams delineation apparatus as in Example 1 to form a pattern in the coating. The pattern was developed at 23°C by immersing the coated wafer in toluene for 60 seconds. The coating was then rinsed with a mixture of toluene-IPA (1:1 in volume ratio) at 23°C for 15 seconds and subsequently rinsed with IPA at 23°C for 15 seconds, and then dried in air. The exposure dose required for gelation (Di) was 0.48µC/$cm^2$, and exposure dose required for obtaining 50% normalized film thickness remainings ($D_{0.5}$) was 1.5 µC/$cm^2$. In this case it had a resolution enough to produce a line-and-space pattern with 1-µm lines and 1-µm spacings.

Comparison Example 1

Into xylene was dissolved polystyrene having $\overline{M}$ w of 39.4X$10^4$ and $\overline{M}$ w/$\overline{M}$ n of 1.06 to prepare 5% resist solution. The resist solution was applied dropwise to a silicon wafer and the wafer was rotated at 500rpm for 5 seconds and then at 1000rpm for 40 seconds to form a coating. The coating was heat-treated in an oven at 80°C for 15 minutes to obtain a coating of 0.5µm in thickness. The coating was exposed to electron beams with the same electron beams delineation apparatus as in Example 1 to form a pattern in the coating. The pattern was developed at 23°C by immersing the coated wafer in toluene for 60 seconds. The coating was then rinsed with a mixture of toluene-IPA (1:1 in volume ratio) at 23°C for 15 seconds and subsequently rinsed with IPA at 23°C for 15 seconds, and then dried in air. The exposure dose required for gelation (Di) was 12µC/$cm^2$, and exposure dose required for obtaining 50% normalized film thickness remainings ($D_{0.5}$) was 26 µC/$cm^2$. In this case it was scarcely possible to produce a line-and-space pattern with 2-µm lines and 2-µm spacings.

## Claims

1. A resist material comprising a polymer containing at least one structural unit (1) represented by the formula

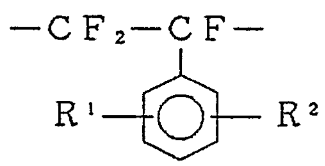

(1)

wherein $R^1$ is hydrogen atom, alkyl having 1 to 3 carbon atoms, alkoxyl having 1 to 3 carbon atoms or halogen atom, $R^2$ is hydrogen atom or haloalkyl having 1 to 3 carbon atoms.

2. A resist material as defined in claim 1 wherein the polymer is a homopolymer containing only the structural unit (1).

3. A resist material as defined in claim 1 wherein the polymer is a copolymer containing at least two kinds of the structural unit (1).

4. A resist material as defined in claim 1 wherein the polymer is a copolymer containing the structural unit (1) and a structural unit derived from other copolymerizable monomer.

5. A resist material as defined in claim 4 wherein the other copolymerizable monomer is styrene, α-methylstyrene, o-, m-or p-methylstyrene, o-, m-or p-ethylstyrene, o-, m-or p-methoxystyrene, aromatic vinyl compounds other than those represented by the formula (1), methyl acrylate, ethyl acrylate or vinyl acetate.

6. A resist material as defined in claim 1 wherein the polymer has a weight average molecular weight ($\overline{M}$ w) of about 5,000 to about 1,000,000.

Fig. 1

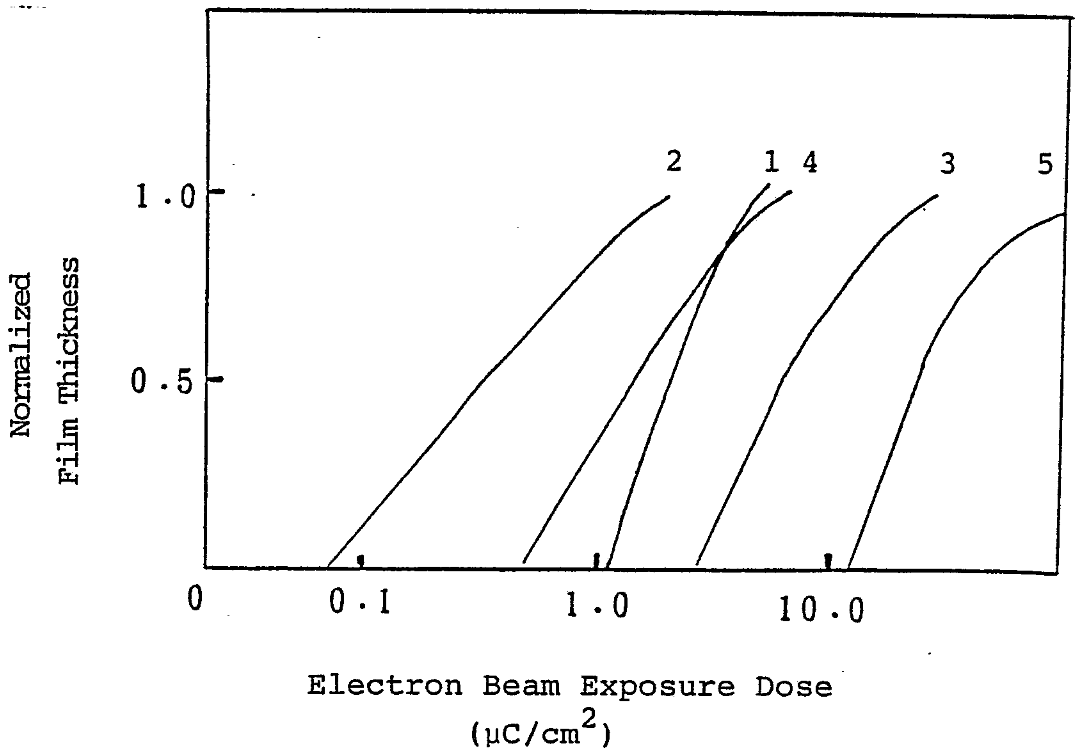
2
1
4
3
5
1.0
0.5
Normalized
Film Thickness
0
0.1
1.0
10.0
Electron Beam Exposure Dose
(μC/cm2)